Europäisches Patentamt

European Patent Office

Office européen des brevets

(11) Numéro de publication: **0 188 965**
A1

# DEMANDE DE BREVET EUROPEEN

(21) Numéro de dépôt: 85402614.3

(22) Date de dépôt: 24.12.85

(51) Int. Cl.⁴: **H 05 K 7/14**, H 01 R 23/68

(30) Priorité: 27.12.84 FR 8419922

(43) Date de publication de la demande: 30.07.86
Bulletin 86/31

(84) Etats contractants désignés: AT BE CH DE FR GB IT LI
LU NL SE

(71) Demandeur: SAPHYMO-STEL, 29, avenue Carnot,
F-91300 - Massy (FR)

(72) Inventeur: Thouvenin, Jean-Marie, THOMSON-CSF
SCPI 173, bld. Haussmann, F-75379 Paris Cedex 08 (FR)
Inventeur: Frot, Dominique, THOMSON-CSF
SCPI 173, bld. Haussmann, F-75379 Paris Cedex 08 (FR)

(74) Mandataire: Phan, Chi Quy et al, THOMSON-CSF
SCPI 19, avenue de Messine, F-75008 Paris (FR)

(54) Bac à cartes électroniques, apte à une connexion électrique par le côté frontal.

(57) Un bac à cartes électroniques (1) muni, dans son fond, d'une carte mère (4) qui assure une liaison électrique de ces cartes électroniques et un câblage conventionnel (5) est caractérisé en ce que la carte-mère (4) comprend en vue d'une connexion électrique par le côté frontal du bac, au moins une portion (6) de sa surface, en saillie, vers l'extérieur, par rapport au plan de l'une des grandes parois du bac (2), et porte, dans la face frontale de cette portion de surface en saillie (6), au moins un connecteur (7) destiné, dans une liaison électrique avec le câblage conventionnel (5), à recevoir un connecteur associé (8) monté sur ce câblage.

# BAC A CARTES ELECTRONIQUES, APTE A UNE CONNEXION ELECTRIQUE PAR LE COTE FRONTAL

L'invention concerne un bac à cartes électroniques, apte à une connexion électrique par le côté frontal.

Dans un bac ou rack à cartes électroniques connu, il est habituel d'utiliser une carte-mère dans le fond du bac pour réaliser une liaison électrique de ces cartes électriques et un câblage conventionnel. Cette carte-mère est souvent en verre époxyde cuivré ou une résine synthétique isolante cuivrée telle que celle commercialisée sous le nom de bakélite, cuivrée. Dans cette carte-mère, les connecteurs électriques qui relient cette dernière aux cartes électroniques du bac sont établis sur une de ses deux faces qui est habituellement sa face frontale tandis que les connecteurs de liaison électrique avec le câblage conventionnel sont fixés sur l'autre face de la carte-mère qui est habituellement la face arrière de cette dernière.

Cette technique connue de liaison électrique qui a l'avantage de ne pas augmenter la hauteur du bac à cartes, rend cependant difficile voire impossible un branchement ou un débranchement du câblage conventionnel de ce bac par son côté frontal et une sortie du bac de son logement s'avère nécessaire. Dans le cas d'un test des liaisons électriques en sortie du bac à cartes, il est également nécessaire de sortir le bac à cartes de son logement et de prévoir en même temps des dispositifs de maintien de ce bac et du dispositif de test. Il en résulte une perte de temps non négligeable.

En outre dans un bac à cartes électroniques connu les opérations de soudage se font habituellement sur les deux faces de la carte-mère. Sur l'une des faces peut être appliquée avantageusement une technique de soudage connue dite soudage à la vague, avec des risques de bouchage de trous formés dans cette carte-mère, et sur l'autre face, le soudage ne peut être exécuté que manuellement, ce qui augmente le coût de fabrication de la carte-mère et par conséquent celui de réalisation du bac ou rack à cartes électroniques.

2

La présente invention ayant pour but d'éviter ces inconvénients, permet de réaliser un bac à cartes électroniques, fiable, économique, muni d'un dispositif amovible de test rapide et de connecteurs favorisant une connexion électrique par le côté frontal du bac permettant un branchement et un débranchement du câblage conventionnel ou l'exécution d'un test rapide sans sortir ce bac, de son logement.

Selon l'invention, un bac à cartes électroniques ayant une forme d'un parallélépipède rectangle à large base, ouvert sur son côté frontal et muni, dans son fond, d'une carte-mère qui assure une liaison électrique de ces cartes électroniques et un câblage conventionnel, est caractérisé en ce que la carte-mère comprend, en vue d'une connexion électrique par le côté frontal du bac, au moins une portion de sa surface, en saillie vers l'extérieur de ce bac, par rapport au plan de l'une des grandes parois ou parois de base de ce dernier, et porte en dehors de ce bac, dans la face frontale de cette portion de surface en saillie, au moins un connecteur destiné, à recevoir un connecteur associé, monté soit sur le câblage conventionnel soit sur un dispositif de test rapide.

Pour mieux faire comprendre l'invention, on décrit ci-après un certain nombre d'exemples de réalisation illustrés par des dessins ci-annexés dont

- la figure 1 représente une vue partielle, schématique, en perspective d'un bac à cartes électroniques, réalisé selon l'invention ;

- la figure 2 représente à une autre échelle, une vue frontale partielle et schématique d'une carte-mère du bac à cartes de la figure 1 ;

- la figure 3 représente une vue de dessous partielle et schématique de la carte-mère de la figure 2 ;

- la figure 4 représente à une autre échelle, une vue latérale partielle schématique du bac à cartes de la figure 1, montrant un connecteur électrique de la face frontale de la carte-mère, en vis-à-vis d'un connecteur électrique associé, monté sur un câblage conventionnel ;

- la figure 5 représente à une autre échelle, une vue de dessus, partielle et schématique du bac à cartes de la figure 4, montrant un connecteur électrique de la face frontale de la carte-mère, en vis-à-vis d'un connecteur associé monté sur un câblage conventionnel ;

- la figure 6 représente à une autre échelle, une vue partielle, schématique, en perspective du bac à cartes de la figure 1, montrant un branchement des connecteurs électriques de la face frontale de la carte-mère et des connecteurs associés, montés sur un câblage conventionnel venant d'un côté latéral du bac ;

- la figure 7 représente une vue partielle, schématique en perspective du bac à cartes, analogue à celle de la figure 6, montrant un branchement des connecteurs électriques de la face frontale de la carte-mère et des connecteurs associés, montés sur un câblage conventionnel venant du côté arrière du bac ;

- la figure 8 représente à une autre échelle, une vue partielle, schématique, en perspective du bac à cartes de la figure 1, muni d'un dispositif amovible de test rapide réalisé selon l'invention monté sur un des connecteurs électriques de la face frontale de la carte-mère de ce bac ;

- la figure 9 représente à une autre échelle, une vue latérale, partielle et schématique du dispositif amovible de test rapide de la figure 8 ;

- la figure 10 représente à une autre échelle, une vue frontale partielle, schématique, en perspective d'une première variante de réalisation du bac à cartes de la figure 1,

- la figure 11 représente une vue frontale partielle, schématique, en perspective d'une deuxième variante de réalisation du bac à cartes de la figure 1 et,

- la figure 12 représente à une autre échelle, une vue partielle schématique en perspective d'une troisième variante de réalisation du bac à cartes de la figure 1.

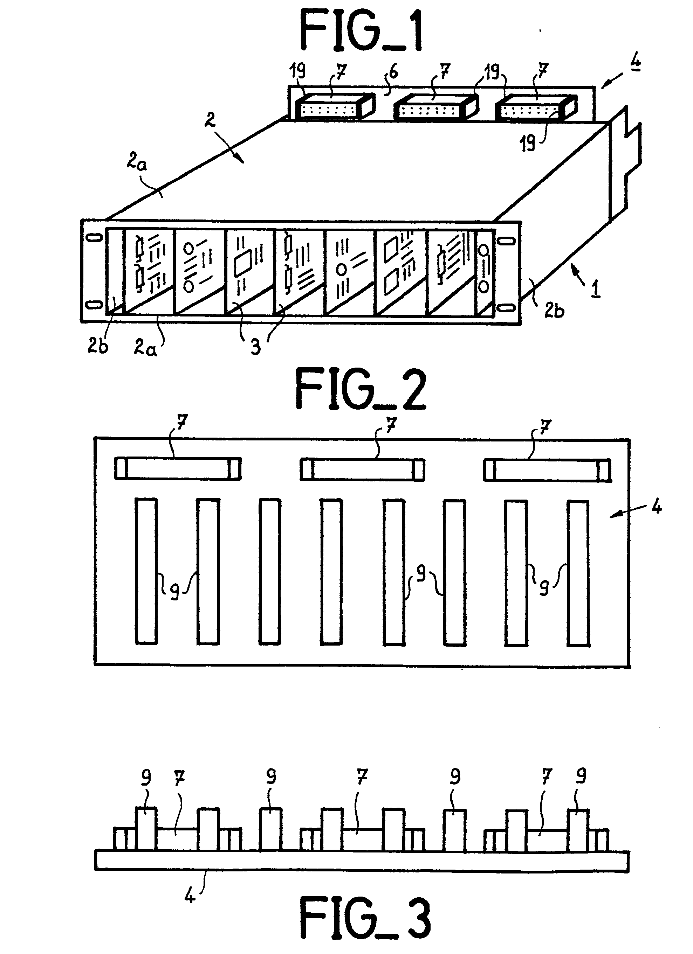

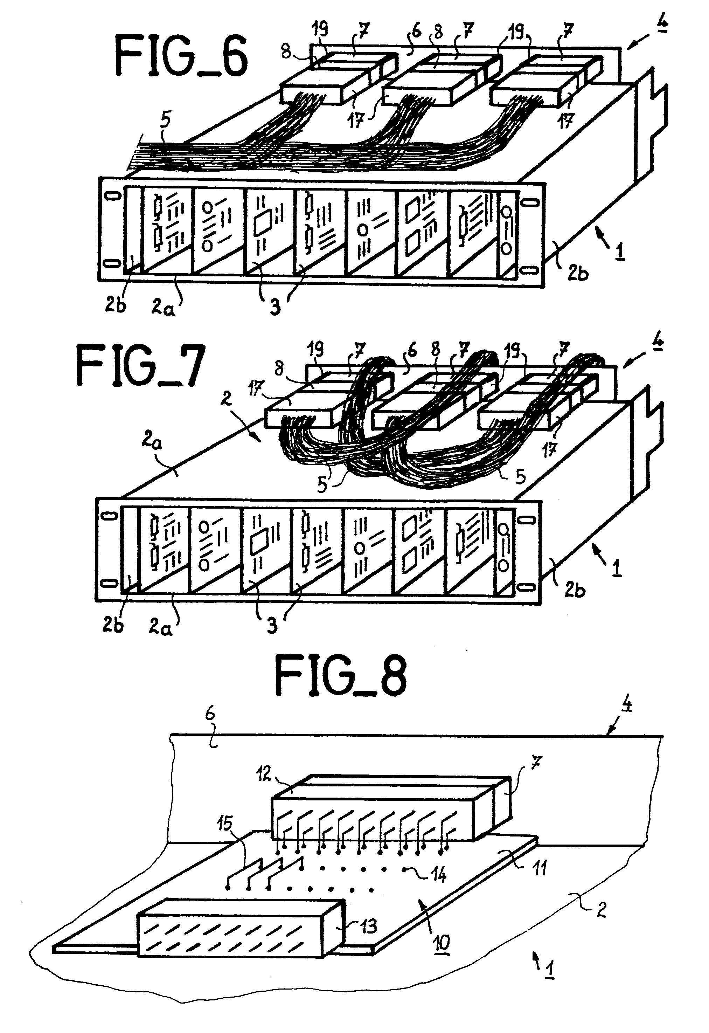

Un bac ou rack à cartes électroniques 1 schématiquement illustré dans la figure 1 comprend un récipient ou bac 2 ayant quatre parois opposées deux à deux, deux grandes parois ou parois de base 2a et deux petites parois ou parois latérales 2b formant de préférence un parallélipipède rectangle à larges bases, ouvert sur son côté frontal, et destiné à recevoir des cartes électroniques 3. Le récipient ou bac 2 est fermé sur son côté arrière ou fond par une carte-mère 4 qui assure une liaison électrique des cartes électriques 3 et un câblage conventionnel 5 (schématiquement représenté dans les figures 6 et 7).

Selon une caractéristique importante, la carte-mère 4 comprend, en vue d'une connexion électrique par le côté frontal du bac, au moins une portion 6 de sa surface, en saillie vers l'extérieur par rapport au plan de l'une des grandes parois ou parois de base 2a du bac 2, et porte dans la face frontale de cette portion de surface en saillie 6, au moins un connecteur 7 destiné, dans une liaison électrique avec le câblage conventionnel 5 (figures 6 et 7), à recevoir un connecteur associé 8 monté sur ce câblage. Les connecteurs 7 et 8 sont des connecteurs de types connus tels que ceux conformes à la norme DIN 41612, ou ceux de la série MMC du constructeur RADIALL. Ces connecteurs peuvent éventuellement être du type cylindrique.

Selon une autre caractéristique, pour réduire l'encombrement du bac à cartes 1, les connecteurs 7 en particulier ceux à forme rectangulaire sont montés sur la carte-mère 4 parallèlement au plan de la grande paroi ou paroi de base adjacente 2a du bac 2 de manière que la hauteur de la portion de surface en saillie 6 de la carte-mère 4 puisse être ramenée à une valeur minimale qui, dans un rangement en superposition des bacs à cartes 1, permet d'obtenir un espace d'écartement minimal entre deux bacs superposés consécutifs 1, sans compromettre un accès frontal aux connecteurs 7, la mise en place et le démontage par le côté frontal des bacs 1 de leurs connecteurs associés 8, autrement dit le branchement ou le débranchement du câblage conventionnel 5 assurant la liaison électrique des bacs à cartes 1. La grande paroi ou paroi de base 2a sert également de support au câblage conventionnel 5 qui a habituellement un poids relativement important, ce qui permet de soulager les connecteurs

5

associés 7 et 8 dans le maintien de ce câblage conventionnel 5 et de conserver d'une manière constante dans le temps, une bonne connexion électrique effectuée par ces connecteurs associés 7 et 8.

Selon un exemple de réalisation la hauteur de la portion de surface en saillie 6 de la carte-mère 4 est de quelques centimètres c'est-à-dire de l'ordre de 3 cm à 5 cm, et l'espace d'écartement entre deux bacs superposés consécutifs 1 est légèrement supérieur à l'épaisseur d'une main à plat, c'est-à-dire de l'ordre de 5 cm à 7 cm.

Selon une autre caractéristique la carte-mère 4 comprend (figures 2 et 3) sur une même de ses faces, tous les composants qui la constituent à savoir par exemple les connecteurs 7 de liaison électrique avec le câblage conventionnel 5 et des connecteurs 9 de liaison électrique avec les cartes électroniques 3. Cette disposition de composants favorise dans la fabrication de la carte-mère 4, une application avantageuse d'une insertion automatique de ces composants et de la technique connue de soudage dite soudage à la vague, qui permet d'obtenir une réduction notable du temps et du coût de fabrication.

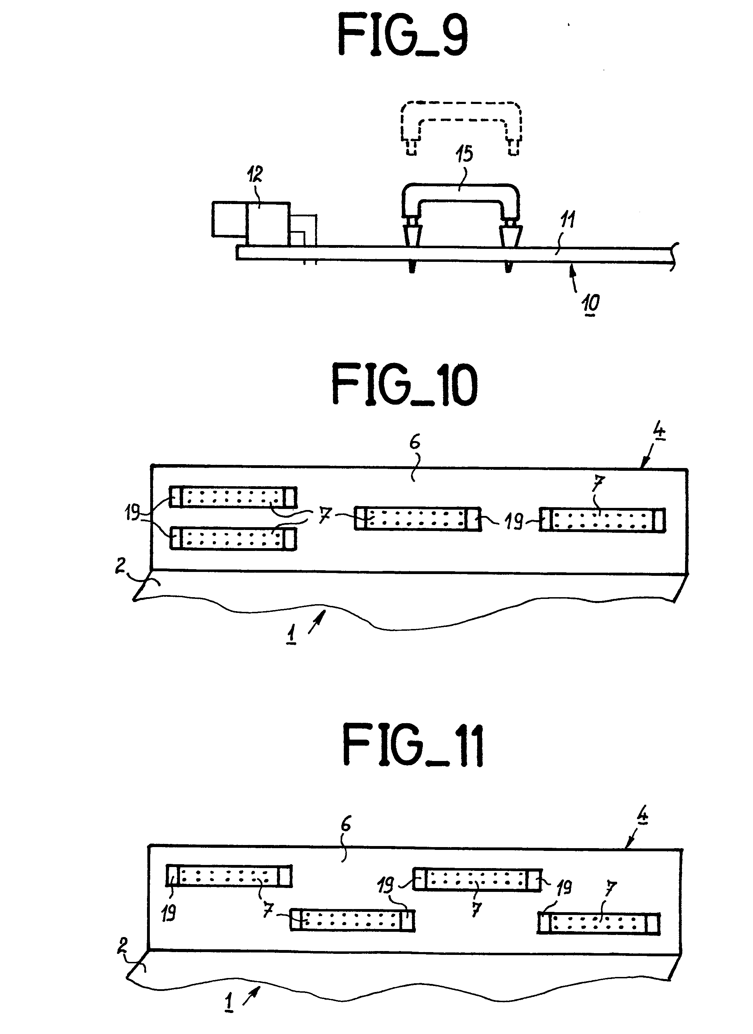

Le bac à cartes électroniques 1 comprend en outre un dispositif amovible de test rapide 10 (figure 8). Le dispositif de test rapide 10 est constitué par une plaque de circuit imprimé 11 relié, par une de ses extrémités, à un connecteur de liaison électrique 12 associable aux connecteurs 7 de la portion de surface en saillie 6 de la carte-mère 4, et par son extrémité opposée, à un connecteur de liaison électrique 13 associable aux connecteurs 8 montés sur le câblage conventionnel 5. Lors d'une insertion du dispositif de test rapide 10 entre la carte-mère 4 et le câblage conventionnel 5 autrement dit lors des accouplements respectifs des connecteurs 7 et 12 (figure 8) et des connecteurs 8 et 13, le circuit imprimé 11 assure une liaison électrique individuelle de chacun des conducteurs du câblage conventionnel 5 avec la carte-mère 4. Le circuit imprimé 11 comprend sur chacune des lignes de liaison électrique entre un conducteur du câblage conventionnel 5 et la carte-mère 4, des prises de tension 14 (figure 8) permettant de suivre l'évolution de chacune de ces liaisons électriques et des cavaliers débrochables 15 (figures 8 et 9) donnant une faculté d'ouvrir chacun des conducteurs du câblage conventionnel 5 pour l'isoler ou pour insérer un dispositif de mesure du courant, non représenté.

Dans le cas où les bacs à cartes électroniques 1 sont disposés en superposition, un accès frontal facile à leurs connecteurs 7 de liaison électrique avec le câblage conventionnel 5 favorise les opérations de test rapide sur les liaisons en sortie de ces bacs à cartes 1 notamment avec le concours de leur dispositif amovible de test rapide 10 dont l'insertion entre la carte-mère 4 et le câblage conventionnel 5 n'exige pas de retrait de ces bacs ou racks à cartes 1 de leur logement, et dont l'utilisation ne nécessite pas de prévision d'un dispositif particulier de maintien, le dispositif de test rapide 10 étant supporté par ces bacs à cartes 1 eux-mêmes. La grande paroi ou paroi de base 2a de ces bacs à cartes 1 constitue un support stable à ce dispositif de test rapide 10 et contribue à soulager les connecteurs 7 et 12 dans le maintien de ce dispositif de test rapide 10 et à obtenir une constante et bonne connexion électrique effectuée par ces connecteurs 7 et 12.

Dans les bacs à cartes électroniques 1, les connecteurs de liaison électrique sont de préférence choisis parmi les connecteurs standardisés conformes à l'une des normes de fabrication largement reconnues telle que la norme DIN 41612.

Dans l'exemple illustré aux figures 1, 2, 3, 6 et 7, la carte-mère 4, ayant une largeur utile de 84 pas de 5,08 millimètres, comprend dans la portion de sa surface en saillie 6, trois connecteurs 7 conformes à la norme DIN 41612 espacés, alignés parallèlement à la grande paroi adjacente 2a du bac 2 et destinés à recevoir trois connecteurs associés 8 montés sur le câble conventionnel 5 venant soit d'un côté latéral avant du bac à cartes 1 (figure 6) soit du côté arrière du bac à cartes 1 (figure 7).

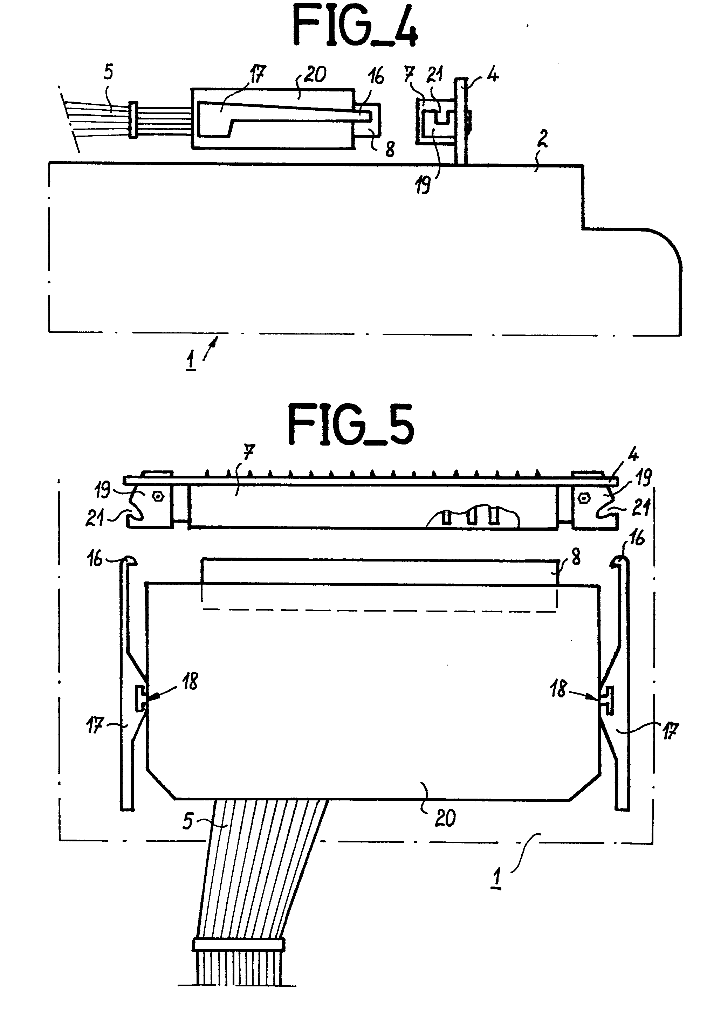

Pour verrouiller la jonction des connecteurs 7 de la carte-mère 4 et ceux 8 du câblage conventionnel (figure 6 et 7) ou le cas échéant des connecteurs 7 de la carte-mère 4 et ceux 12 du dispositif de test rapide 10 ou des connecteurs 8 du câblage conventionnel 5 et ceux 13 du dispositif de test rapide 10 (figure 8) d'une part les connecteurs 8 du câblage conventionnel 5 (figure 5) et éventuellement ceux 12 du dispositif de test rapide 10 sont munis, au niveau de leurs deux extrémités, de crochets 16 de deux pinces latérales 17, pivotables dans un plan parallèle au plan longitudinal de symétrie de ces connecteurs 8 ou 12 autour des axes 18 orthogonaux à ce plan, et constamment rappelées dans leur position de verrouillage (figure 5), et d'autre part les connecteurs 7 de la portion de surface en saillie 6 de la carte-mère 4 (figure 5) et éventuellement ceux 13 du dispositif de test rapide 10 sont respectivement pourvus au niveau de leurs deux extrémités, de deux pièces d'ancrage 19 destinées à recevoir dans leurs creux 21, des crochets 16 des deux pinces de verrouillage 17. Dans l'exemple illustré aux figures 4 et 5, les deux pinces latérales de verrouillage 17 d'un connecteur 8 sont montées sur les bords latéraux opposés d'une pièce sensiblement rectangulaire 20 fixée sur ce connecteur 8 ou rendue solidaire de ce dernier par son bord se trouvant à proximité des crochets 16 de ces pinces 17, cette pièce 20 servant également de couvercle protégeant les parties terminales des conducteurs du câblage conventionnel 5 reliés au connecteur 8, tandis que les deux pièces d'ancrage 19 destinés à recevoir les crochets 16 de ces pinces 17 sont soudées sur la carte-mère 4 au niveau des deux extrémités du connecteur 7.

Lors d'une jonction d'un connecteur 7 et d'un connecteur 8, les deux crochets 16 appartenant au connecteur 8 sont préalablement écartés l'un par rapport à l'autre par pression sur les extrémités des pinces 17 opposées à ces crochets 16, qui fait pivoter ces pinces 17 autour de leurs axes 18, avant une introduction, l'un dans l'autre de ces deux connecteurs 7 et 8 et un verrouillage de leur jonction, par relâchement des pinces 17 qui sont automatiquement rappelées dans leur position de verrouillage selon laquelle les crochets 16 de ces pinces 17 pénètrent et sont retenus dans les creux respectifs 21 de ces deux pièces d'ancrage 19. Le câblage conventionnel 5 est ainsi branché sur la carte-mère 4 du bac à cartes 1. Dans un débranchement du câblage conventionnel 5, les crochets 16 des pinces 17 du connecteur 8 sont préalablement dégagés des creux 21 des pièces d'ancrage 19 par pression sur les extrémités de ces pinces 17 opposées aux crochets 16 avant le retrait du connecteur 8.

Le branchement et le débranchement du câblage conventionnel 5 se font ainsi facilement par le côté frontal des bacs à cartes 1 sans nécessiter une sortie de ces bacs de leur logement.

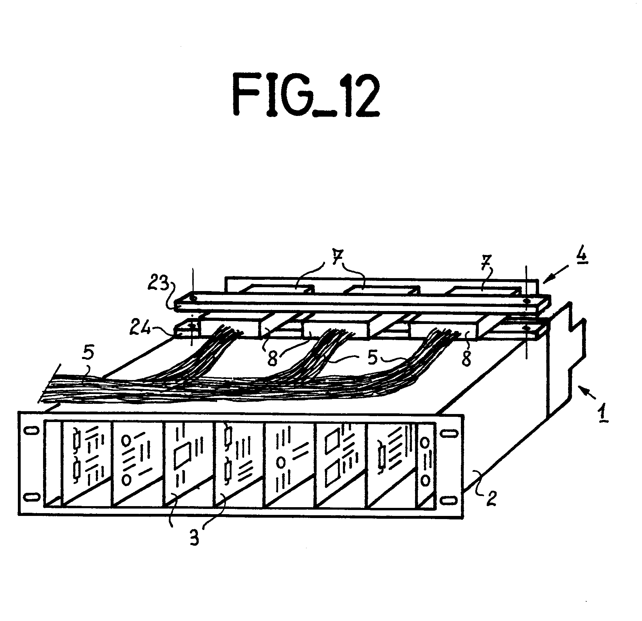

Dans une variante de réalisation, sur la face frontale de la portion de surface en saillie 6 de la carte-mère 4, les connecteurs 7 sont montés, parallèlement au plan de la grande paroi adjacente 2a du bac 2, l'un au-dessus de l'autre (figure 10) ou en quinconce ou décalage(figure 11).

Selon l'invention dans la fabrication de la carte-mère 4, le concepteur a un avantage d'avoir un libre choix d'une implantation en câblage simple face ou double face alors que selon la technique habituelle de montage sur deux faces de la carte-mère des bacs à cartes électroniques connus rappelés dans un paragraphe précédent, il doit faire appel à un câblage en double face à trous métallisés dont les inconvénients sont déjà largement connus.

Dans une autre variante de réalisation où le câblage conventionnel 5 est d'un poids relativement important, les connecteurs 8 étant en porte à faux, sont avantageusement soutenus par des supports ou brides. Selon l'exemple illustré à la figure 12, les connecteurs 8 portant le câblage conventionnel 5 sont maintenus et supportés par deux brides 23 , 24 fixées sur la paroi du bac 2.

Un bac ou rack à cartes électroniques réalisé selon l'invention comprend ainsi de grands avantages : un accès frontal facile à ses connecteurs de liaison électrique, une disposition favorable à un test rapide de ses liaisons électriques, et un coût économique de fabrication.

REVENDICATIONS

1. Bac à cartes électroniques ayant une forme d'un parallélépipède rectangle à large base, ouvert sur son côté frontal et muni, dans son fond, d'une carte-mère qui assure une liaison électrique de ces cartes électroniques et un câblage conventionnel (5), caractérisé en ce que la carte-mère (4) comprend, en vue d'une connexion électrique par le côté frontal du bac, au moins une portion (6) de sa surface, en saillie vers l'extérieur de ce bac, par rapport au plan de l'une des grandes parois ou paroi de base (2a) de ce dernier (2), et porte en dehors de ce bac, dans la face frontale de cette portion de surface en saillie (6), au moins un connecteur (7) destiné à recevoir un connecteur associé (8 , 12) monté soit sur le câblage conventionnel (5) soit sur un dispositif de test rapide (10).

2. Bac selon la revendication 1, caractérisé en ce que sur la carte-mère (4), dans la face frontale de la portion de surface en saillie (6), les connecteurs (7) en particulier ceux à forme rectangulaire sont montés parallèlement au plan de la grande paroi ou paroi de base (2a) du bac (2).

3. Bac selon la revendication 2, caractérisé en ce que sur la carte-mère (4), dans la face frontale de la portion de surface en saillie (6), les connecteurs (7) de liaison électrique avec le câblage conventionnel (5) sont disposés en quinconce.

4. Bac selon la revendication 1, caractérisé en ce qu'il comprend un dispositif amovible de test rapide (10), constitué par une plaque de circuit imprimé (11) qui, relié, par une de ses extrémités à un connecteur de liaison électrique (12) associable aux connecteurs (7) de la portion de surface en saillie (6) de la carte-mère, et par son extrémité opposée, à un connecteur de liaison électrique (13) associable aux connecteurs (8) du câblage conventionnel (5), assure une liaison électrique individuelle de chacun des conducteurs de ce câblage conventionnel (5) avec la carte-mère (4).

5. Bac selon la revendication 4, caractérisé en ce que dans le dispositif amovible de test rapide (10), la plaque de circuit imprimé (11) comprend des prises de tension (14) sur chacune des lignes de liaison électrique entre un conducteur du câblage conventionnel (5) et la carte-mère (4) et des cavaliers débrochables (15).

6. Bac selon la revendication 1, caractérisé en ce que dans la carte-mère, la portion de surface en saillie (6) a une hauteur de l'ordre de 3 cm à 5 cm.

7. Bac selon la revendication 1, caractérisé en ce qu'il comprend au niveau des deux extrémités de chacun des connecteurs (7) de la portion de surface en saillie (6) de la carte-mère (4), deux pièces d'ancrage (19) destinées à recevoir dans leurs creux (21), des crochets (16) de deux pinces latérales de verrouillage (17) solidaires des connecteurs (8, 12) associés à des connecteurs (7) de la carte-mère (4).

8. Bac selon l'une des revendications 1 et 2, caractérisé en ce qu'il comprend des brides (23 , 24) fixées sur les parois du bac (2) et destinées à maintenir et à supporter les connecteurs associés (8) montés sur le câblage conventionnel (5).

FIG_1

FIG_2

FIG_3

# FIG_4

# FIG_5

FIG_6

FIG_7

FIG_8

# FIG_9

# FIG_10

# FIG_11

# FIG_12

**Office européen des brevets**

**RAPPORT DE RECHERCHE EUROPEENNE**

**0 188 965**

EP 85 40 2614

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-1 545 718 (SIEMENS) <br> * En entier * | 1,2 | H 05 K 7/14 <br> H 01 R 23/68 |
| A | DE-A-2 635 336 (SIEMENS) <br> * Page 4, lignes 15-35; figure 1 * | 1,2,8 | |
| A | FR-A-2 478 422 (SOC. AN. DE TELECOMMUNICATIONS) <br> * Page 4, lignes 5-9; figures 2,6 * | 1,2 | |
| A | FR-A-2 389 298 (IBM) <br> * Page 8, lignes 11-14; figures 1-3 * | 1,2 | |
| A | DE-A-3 001 870 (LICENTIA) <br> * Page 12, dernière alinéa - page 13, ligne 2; page 14, alinéa 1 - page 18, alinéa 1; figures * | 1,2 | **DOMAINES TECHNIQUES RECHERCHES (Int. Cl.4)** <br><br> H 05 K <br> H 01 R |
| A | FR-A-2 448 235 (SADAR) <br><br> * En entier * | 1,4,7,8 | |
| A | FR-A-1 432 020 (VEB BUCHUNGSMASCHINENWERK) <br> * En entier * | 1,4,7 | |

Le présent rapport de recherche a été établi pour toutes les revendications

| Lieu de la recherche <br> LA HAYE | Date d'achèvement de la recherche <br> 04-04-1986 | Examinateur <br> RAMBOER P. |
|---|---|---|